(19) Europäisches Patentamt / European Patent Office / Office européen des brevets

(11) **EP 4 741 842 A1**

(12) **EUROPEAN PATENT APPLICATION**

(43) Date of publication:
**13.05.2026 Bulletin 2026/20**

(21) Application number: **24306865.7**

(22) Date of filing: **06.11.2024**

(51) International Patent Classification (IPC):
***G01R 27/26*** *(2006.01)*

(52) Cooperative Patent Classification (CPC):
**G01R 27/2605**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ALSTOM Holdings**
**93400 Saint-Ouen-sur-Seine (FR)**

(72) Inventor: **Neugebauer, Andreas**
**64347 Griesheim (DE)**

(74) Representative: **Brunotte, Joachim Wilhelm Eberhard**
**Patentanwälte Bressel und Partner mbB**
**Potsdamer Platz 10**
**10785 Berlin (DE)**

(54) **METHOD FOR DETERMINING A CAPACITANCE VALUE OF A CAPACITOR OF A RC CIRCUIT ON A DC LINK OF A VEHICLE**

(57) It is proposed a method for determining a capacitance value (C) of a capacitor (CA) of a RC circuit on a DC link (DCL) of a vehicle, wherein the RC circuit comprises a charging resistor (RE) or a discharging resistor (RD), the method comprising the following steps:

a) measuring a sequence of values (U0-U20; U0-new-U20-new) of a charging voltage (Ut) or a discharging voltage (Ud) of the capacitor (CA) over an evaluation time interval (T1),

b) determining
- a value or
- a definite integral with respect to time
of a first time derivative of the sequence of values (U0-U20; U0-new-U20-new) of the charging voltage (Ut) or the discharging voltage (Ud) in the evaluation time interval (T1),

c) determining
- a value or
- a definite integral with respect to time
of a second time derivative of the sequence of values (U0-U20; U0-new-U20-new) of the charging voltage (Ut) or the discharging voltage (Ud) in the evaluation time interval (T1), d) determining the capacitance value (C) of the capacitor (CA) by using one of the following relations:
- the negative quotient of the value of the first time derivative and the value of the second time derivative, wherein the negative quotient is divided by a known resistance value (R) of the charging resistor (RE) or the discharging resistor (RD), gives the capacitance value (C), or
- the negative quotient of the definite integral of the first time derivative and the definite integral of the second time derivative, wherein the negative quotient is divided by a known resistance value (R) of the charging resistor (RE) or the discharging resistor (RD), gives the capacitance value (C).

Furthermore, a corresponding system and a vehicle comprising the system are proposed.

Fig.1

**Description**

The invention relates to a method for determining a capacitance value of a capacitor of a RC circuit on a DC link of a vehicle, a system configured to perform the method and a vehicle comprising the system.

Capacitors are commonly used in DC links of traction converters of vehicles, particularly railway vehicles, particularly in RC circuits with a charging resistor and/or a discharging resistor. In this respect, capacitors particularly can serve as filter capacitors. In operation, capacitance values decrease over time as a result of aging. In order to prevent consequential damage, particularly of traction converter components due to reduced filtering capabilities, an accurate capacitance supervision is required. If progressed aging is detected, it can be necessary to replace capacitors.

It is known to use measured values of a charging current and measured values of a charging voltage of a capacitor to determine a capacitance value based on the differential equation $I = C * dU(t)/dt$, rearranged $C = I / (dU(t)/dt)$, wherein I is the charging current, C is the capacitance value, U(t) is the charging voltage, dU(t)/dt is the first derivative with respect to time t of the charging voltage.

In practice, this method may be unreliable. The charging resistor reduces the charging current to very low values. These low charging current values can be below accuracy limits of measuring devices, such as current transformers.

Furthermore, the resolution of A/D converters being used (such a resolution can be, for example, 1 A) is insufficient for use in low value ranges, for example ranges below 10 A. The resolution characterizes the minimal difference between two current values between which the A/D converters can distinguish.

It is an object of the present invention to propose a method for determining a capacitance value of a capacitor of a RC circuit on a DC link of a vehicle with an improved accuracy, wherein the implementation and the utilization of the method should be simple and cost-effective.

The object is solved according to the invention by a method according to claim 1, a system according to claim 5 and a vehicle according to claim 6.

In particular, it is proposed a method for determining a capacitance value of a capacitor of a RC circuit on a DC link of a vehicle, wherein the RC circuit comprises a charging resistor or a discharging resistor, the method comprising the following steps:

> a) measuring a sequence of values of a charging voltage or a discharging voltage of the capacitor over an evaluation time interval,
> b) determining
>
> - a value or
> - a definite integral with respect to time
>
> of a first time derivative of the sequence of values of the charging voltage or the discharging voltage in the evaluation time interval,
> c) determining
>
> - a value or
> - a definite integral with respect to time
>
> of a second time derivative of the sequence of values of the charging voltage or the discharging voltage in the evaluation time interval,
> d) determining the capacitance value of the capacitor by using one of the following relations:
>
> - the negative quotient of the value of the first time derivative and the value of the second time derivative, wherein the negative quotient is divided by a known resistance value of the charging resistor or the discharging resistor, gives the capacitance value, or
> - the negative quotient of the definite integral of the first time derivative and the definite integral of the second time derivative, wherein the negative quotient is divided by a known resistance value of the charging resistor or the discharging resistor, gives the capacitance value.

"At least one" has the same meaning as "one or a plurality". The terms "in part" or "partially" or "at least partially" have the same meaning as "partially or wholly". In the following, features are sometimes described in the singular. Such a description alternatively or additionally includes a corresponding disclosure for a plurality of such features, if applicable, and vice versa.

The "definite integral of the first time derivative" is the "definite integral with respect to time of the first time derivative". The "definite integral of the second time derivative" is the "definite integral with respect to time of the second time derivative". The term "evaluation time interval" can generally mean, that all values in it or a part of or parts of the values in it can be used for evaluation purposes and/or further calculations.

The vehicle particularly can be a railway vehicle, for example a locomotive or a traction wagon, for example of a tramway or a subway train or a light rail system or a regional train or an interregional train or a long-distance train or a highspeed train. The vehicle comprises the DC link and a traction system, in which electric traction energy is transmitted via the DC link to at least one electric traction engine. Alternatively, the vehicle can be an electric bus, an electric car or any electrically powered road or rail vehicle comprising a DC link. Alternatively, the vehicle can be a hybrid vehicle comprising a DC link.

The DC link can be a part of a traction converter of the vehicle. The capacitor can be any capacitor used in DC links of traction converters of vehicles, particularly a filter capacitor. It can be provided in series connection with the charging resistor (or in parallel connection with the discharging resistor) to form the RC circuit. The RC circuit can be an RC element. The capacitor and the charging resistor can be arranged in series connection. The capacitor and the discharging resistor can be arranged in parallel connection. The RC circuit can mean a series connection of the capacitor and the charging resistor. The RC circuit can mean a parallel connection of the capacitor and the discharging resistor. The DC link can be a DC intermediate circuit. DC stands for direct current. In the DC link, the capacitor is charged or discharged particularly when a DC voltage in the DC link changes.

The RC circuit on a DC link of the vehicle can mean, that the RC circuit is electrically connected to the DC link. The capacitor can be a part of the DC link. In embodiments of the method, in which the charging resistor is used, the charging resistor can be a part of a DC charging circuit which is connected to the capacitor and which is, thus, also connected to the DC link of the vehicle.

In embodiments of the method, in which the discharging resistor is used, the discharging resistor can be a part of a discharging circuit which also includes the capacitor. To realize discharging, the discharging circuit has to be a closed circuit. Such a closed circuit can be for example realizable with the discharging resistor permanently connected to the capacitor. After the DC link has been charged, a supply voltage must be disconnected in order to discharge the DC link via the (passive) discharging resistor - when needed for carrying out the inventive method - by using a controllable switch or a plurality of controllable switches. The switch or the switches can be configured to allow changing between the following states:

- supply voltage connected to the DC link (normal operating state when the method is not carried out) and
- supply voltage disconnected from the DC link (when the method is carried out).

An embodiment of the method including the charging resistor and the discharging resistor is furthermore possible. The steps a) to d) can then be carried out multiple times by measuring and using the sequence of values of the charging voltage or the discharging voltage (as selected). The steps a) to d) can then be carried out by measuring and using the sequence of values of the charging voltage and the discharging voltage in a combined manner. That means, the method can be carried out multiple times, at least one time by measuring and using the sequence of values of the charging voltage and at least one time by measuring and using the sequence of values of the discharging voltage. Obtained results (capacitance values) of both presented possibilities can be combined to obtain a final capacitance value result, for example by averaging.

The method (in all presented embodiments as well as a system configured to perform the method in all presented embodiments) can be performed at least partially automatically. A measuring device, configured to measure the sequence of values of the charging voltage (or the discharging voltage), can be provided. The measuring device can be or can comprise a voltmeter. The measuring device can be connected (for example wire-based or wirelessly) to a computing device. The computing device can comprise an input device, an output device, a data storage, a random access memory, a hard drive and a processor. The computing device can be configured

- to determine the value or the definite integral of the first time derivative and
- to determine the value or the definite integral of the second time derivative and
- to determine the capacitance value by using one of the stated relations.

The values of the charging voltage (or the discharging voltage) can be discrete values, that can each be measured at discrete time steps with, in each case, a predefined time duration (increment or step size) between the time steps. The predefined time duration can be always the same between measurements. The predefined time duration (which can also be denoted as "cycle" or "cycle time") can, for example, be in the region of milliseconds, for example 1, 2, 4, 10, 15 or 20 ms. The evaluation time interval can comprise a plurality of cycles, for example 4 cycles with 5 sample values, 20 cycles with 21 sample values, 21 cycles with 22 sample values, 39 cycles with 40 sample values or 100 cycles with 101 sample values. The values of the charging voltage (or the discharging voltage) can be measured as the voltage over (or of or along) the capacitor.

The method can comprise measuring time, for example to ensure that the predefined time duration between the time steps in each case has the same length. Furthermore, the (known) predefined time duration between the time steps (which can be a predefined and constant calculation cycle time) can be used to allocate a time value to each of the values of the charging voltage (or the discharging voltage) for further calculations.

The sequence of the values of the charging voltage (or the discharging voltage) can be represented as a curve or as another form of visual representation. The curve of the values of the charging voltage (or the discharging voltage) can be obtained by interpolation. The term "interpolation" only refers to the curve between the discrete value points. However, these intermediate values may not be used in the method, they may only be used to visualize the (continuous) curve and to graphically link the (discrete) values. The sequence of the values of the charging voltage (or the discharging voltage) can alternatively or additionally be represented and/or stored as a value table.

The sequence of values of the charging voltage (or the discharging voltage) can comprise a plurality of values of the charging voltage (or the discharging voltage), for example 5, 21, 22, 40 or 101 values of the charging voltage (or the discharging voltage).

The determining of the value of the first time derivative of the sequence of the values of the charging voltage (or the discharging voltage) can particularly be performed by using numerical differentiation. The value of the first time derivative can particularly be obtained by using numerical differentiation with regard to the whole evaluation time interval (that can mean determining a slope by building a differential or, more exact, a difference quotient over the whole evaluation time interval) or a subinterval of the evaluation time interval.

The value of the first time derivative can be a value of the slope of the sequence of the values of the charging voltage (or the discharging voltage) and/or the curve of the values of the charging voltage (or the discharging voltage). The first time derivative can be a sequence of values over time, particularly, if obtained by numerical differentiation. It is alternatively possible that the first time derivative can be defined as a function of time.

The determining of the definite integral of the first time derivative of the sequence of the values of the charging voltage (or the discharging voltage) can (starting from the sequence of the values of the charging voltage or the discharging voltage) particularly be performed by using, at first, numerical differentiation and, afterwards, numerical integration. The definite integral of the first time derivative can particularly be obtained by using, at first, numerical differentiation with regard to values of the charging voltage (or the discharging voltage) of the whole evaluation time interval (that can mean determining a slope by building a differential or, more exact, a difference quotient over the whole evaluation time interval) or a subinterval of the evaluation time interval and, afterwards, numerical integration with regard to the whole evaluation time interval or a subinterval of the evaluation time interval.

The definite integral of the first time derivative can be a definite integral over values of the slope of the sequence of the values of the charging voltage (or the discharging voltage) and/or the curve of the values of the charging voltage (or the discharging voltage) with respect to time.

A "definite" integral generally computes an area of a region in a plane that is bounded by the graph of a given function and the abscissa between two points (a starting point and an end point) on the abscissa (which is the horizontal axis). A "definite" integral thus gives a concrete value (the area between the graph and the abscissa between the two points). The starting point and the end point of the definite integral of the first time derivative can be the beginning point in time and the end point in time of the evaluation time interval or of the subinterval of the evaluation time interval.

The determining of the value of the second time derivative of the sequence of the values of the charging voltage (or the discharging voltage) can particularly be performed by using numerical differentiation. The value of the second time derivative can particularly be obtained by using numerical differentiation with regard to the whole evaluation time interval (that can mean determining a value by building a differential or, more exact, a difference quotient over the whole evaluation time interval with regard to values of the first time derivative) or a subinterval of the evaluation time interval. The second time derivative means two derivations in time one after another, that means, the original given function (sequence of the values of the charging voltage or the discharging voltage) is differentiated twice. The second time derivative generally is the curvature of an original given function.

The second time derivative generally differs from the first time derivative (at least by a factor, if an exponential approach is used to describe the second time derivative and the first time derivative).

The value of the second time derivative can be a value of the slope and/or the gradient of a sequence of values of the first time derivative of the sequence of values of the charging voltage (or the discharging voltage). The value of the second time derivative can be a value of the curvature of the sequence of values of the charging voltage (or the discharging voltage). The second time derivative can be a sequence of values over time, particularly, if obtained by numerical differentiation. It is alternatively possible that the second time derivative is defined as a function of time.

The determining of the definite integral of the second time derivative of the sequence of the values of the charging voltage (or the discharging voltage) can (starting from the sequence of the values of the charging voltage or the discharging voltage) particularly be performed by using, at first, two runs of numerical differentiation and, afterwards, one run of numerical integration. The definite integral of the second time derivative can particularly be obtained by performing, at first, two runs of numerical differentiation with regard to values of the charging voltage (or the discharging voltage) of the whole evaluation time interval (that can mean determining a value by building a differential or, more exact, a difference quotient over the whole evaluation time interval with regard to values of the charging voltage (or the discharging voltage) [first run] and the first time derivative [second run]) or a subinterval of the evaluation time interval and, afterwards, one run of numerical integration with regard to the whole evaluation time interval or the subinterval or a further subinterval of the evaluation time interval.

The definite integral of the second time derivative can be an integral over values of the slope of a sequence of values of the first time derivative of the sequence of values of the charging voltage (or the discharging voltage) with respect to time. The definite integral of the second time derivative can be an integral over values of the curvature of the sequence of values of the charging voltage (or the discharging voltage) with respect to time.

The starting point and the end point of the definite integral of the second time derivative can be the beginning point in time and the end point in time of the evaluation time interval or of the subinterval or of a further subinterval of the evaluation time interval.

The definite integral of the second time derivative can be integrated over the same time interval as the definite integral of the first time derivative. The definite integral of the first time derivative and the definite integral of the second time derivative both can be integrated over the evaluation time interval or a subinterval of the evaluation time interval.

Mentioned subintervals for determining the value of the first time derivative and/or the definite integral of the first time derivative and/or the value of the second time derivative and/or the definite integral of the second time derivative can match in length.

The mathematical relation "the negative quotient of the value of the first time derivative and the value of the second time derivative, wherein the negative quotient is divided by a known resistance value of the charging resistor or the discharging resistor, gives the capacitance value" can be written as equation as follows:

$$-((dU\sim/dt)/(d^2U\sim/dt^2))/R = tau/R = C,$$

wherein C is the capacitance value sought-for, $dU\text{-}/dt$ is the value of the first time derivative of the charging voltage (or the discharging voltage), $d^2U\sim/dt^2$ is the value of the second time derivative of the charging voltage (or the discharging voltage), R is the (known) resistance value, t is time. The tilde "~" is used to indicate a concrete value of the first time derivative respectively a concrete value of the second time derivative. The negative quotient of the value of first time derivative and the value of the second time derivative gives the time constant of the RC circuit generally being denoted with the Greek letter "tau". The time constant tau further equals the product of the capacitance value and the resistance value: tau = C*R.

The above mentioned equation can be derived as follows:
It is based on the following exponential formula of the charging voltage:

$U(t) = U\_DCsupply*(1-e^{(-t/tau)})$, wherein U_DCsupply is a supply voltage of the RC circuit that can be measured and/or is known and U(t) is the charging voltage,

with the first time derivative

$$dU(t)/dt = U\_DCsupply*(e^{(-t/tau)})/tau,$$

and the second time derivative

$$d^2U(t)/dt^2 = -U\_DCsupply*(e^{(-t/tau)})/tau^2.$$

It is based on the following exponential formula of the discharging voltage:

$U(t) = U(0)*e^{(-t/tau)}$, wherein U(0) is the initial discharge voltage of the RC circuit that can be measured and U(t) is the discharging voltage,
with the first time derivative

$$dU(t)/dt = -U(0)*(e^{(-t/tau)})/tau,$$

and the second time derivative

$$d^2U(t)/dt^2 = U(0)*(e^{(-t/tau)})/tau^2.$$

The negative quotient of the first time derivative and the second time derivative thus gives the time constant tau:

$$-(dU(t)/dt)/(d^2U(t)/dt^2) = tau.$$

From here, it follows that

$$-((dU(t)/dt)/(d^2U(t)/dt^2))/R = tau/R = C.$$

Since concrete values of the first time derivative and the second time derivative can be determined by the sequence of values of the charging voltage (or the discharging voltage), it follows the above-mentioned relation:

$$-((dU{\sim}/dt)/(d^2U{\sim}/dt^2))/R = tau/R = C.$$

As an alternative, particularly when using numerical integration,

-    the (with respect to time) definite integral of the first time derivative
-    and the (with respect to time) definite integral of the second time derivative can be used instead of the value of the first time derivative and the value of the second time derivative. This leads to the mathematical relation: "the negative quotient of the definite integral of the first time derivative and the definite integral of the second time derivative, wherein the negative quotient is divided by a known resistance value of the charging resistor or the discharging resistor, gives the capacitance value":

$$-(Integral(dU(t)/dt)*dt)/(Integral(d^2U(t)/dt^2)*dt)/R = tau/R = C.$$

In numerical integration, integrating can particularly mean summing up values of a sequence to be integrated (here: values of the first time derivative or values of the second time derivative) and multiplying the summed up values with a time duration between the values, which can be the predefined time duration or cycle or a number of cycles. The predefined time duration or cycle or number of cycles can be reduced from the numerator and the denominator of the quotient, so that both, the definite integral of the first time derivative and the definite integral of the second time derivative, can be summed up values of the first time derivative (numerator) and the second time derivative (denominator).

An example of a calculation of the capacitance value is described in the following (without limiting the generality of the other statements):

A concrete sequence of 22 values of the charging voltage (or the discharging voltage) is given. They are denoted as U0, U1... U21, wherein the numbers are to be understood as an index and can also be written as small indices. The 22 values of the charging voltage (or the discharging voltage) are recorded at discrete points in time in each case being separated by a predefined cycle time (4 ms in this example). That is, a step size of 4 ms is used. The capacitance value can be calculated by the following formula:

$$C = -\frac{\int \frac{dU(t)}{dt} dt}{\int \frac{d^2U(t)}{dt^2} dt} \bigg/ R = -\frac{\sum_{i=20}^{21}(U_{i-5} - U_{i-15}) \cdot tspan}{\sum_{i=20}^{21}(U_{i-20} + U_i - 2 \cdot U_{i-10})} \bigg/ R$$

wherein i is a summation index and tspan is the predefined time duration (here: a used subinterval for the shown derivation comprises 10 cycles with 10 x 4 ms = 40 ms).

Carrying out the two summations (this includes inserting the concrete values of the charging voltage or the discharging voltage) gives:

$$C = -\frac{(-U_5 - U_6 + U_{15} + U_{16}) \cdot tspan}{(U_0 + U_1 - 2 \cdot U_{10} - 2 \cdot U_{11} + U_{20} + U_{21})} / R.$$

In the following table, the factor and sign of each value of the charging voltage (or the discharging voltage) is given:

Table 1: Factor and sign of each value of the charging voltage (or the discharging voltage)

| Sign in the numerator | | | | | | - | - | | | | | | | | | + | + | | | | | |
|---|---|---|---|---|---|---|---|---|---|---|---|---|---|---|---|---|---|---|---|---|---|---|
| Index | 0 | 1 | 2 | 3 | 4 | 5 | 6 | 7 | 8 | 9 | 10 | 11 | 12 | 13 | 14 | 15 | 16 | 17 | 18 | 19 | 20 | 21 |
| Sign in the denominator | + | + | | | | | | | | | - | - | | | | | | | | | + | + |
| factor | 1 | 1 | | | | 1 | 1 | | | | 2 | 2 | | | | 1 | 1 | | | | 1 | 1 |

It should be noted, that in the final calculation, only 10 of the 22 values of the charging voltage (or the discharging voltage) are eventually needed.

If a larger number of values of the charging voltage (or the discharging voltage) is available, the above-mentioned formula to calculate the capacitance value can read, for example for 40 values of the charging voltage (or the discharging voltage) (U0, U1...U39):

$$C = -\frac{\sum_{i=20}^{39}(U_{i-5} - U_{i-15}) \cdot tspan}{\sum_{i=20}^{39}(U_{i-20} + U_i - 2 \cdot U_{i-10})} / R.$$

In this example, in which the number of values of the charging voltage (or the discharging voltage) is 40 and a subinterval for the shown derivation of 10 cycles is used, all 40 values of the charging voltage (or the discharging voltage) are included in the result. If more than 40 values of the charging voltage (or the discharging voltage) are used, the first 20 and last 20 values of the charging voltage (or the discharging voltage) are included in the final result.

If the quotient of the number of values of the charging voltage (or the discharging voltage) / and the subinterval for the derivation is above 4, the inner values of the charging voltage (or the discharging voltage) cancel each other out when carrying out the two summations in the numerator and the denominator.

When the capacitance value is determined, it can be, for example,

- stored in a database
- compared with prior capacitance values, particularly to assess aging and/or a state of the capacitor.

Aging (particularly in form of a decrease of the capacitance value [particularly in comparison to a prior capacitance value or a nominal capacitance value] above a threshold percentage value) and/or a capacitance value below a threshold value (that can be defined as aging) can be detected. A signal, for example an alert signal or a warning signal, can be put out, for example to a driver of the vehicle or a technician or a maintenance center, if aging and/or a capacitance value below the threshold value is detected. Such a signal can be transmitted wirelessly or by using a wire. It can be transmitted to an output device, like a monitor or a computer comprising a data storage memory. It can alternatively or additionally be transmitted to be stored in an error memory of the vehicle.

The present invention is an accurate and simple method to measure aging of a capacitor of a RC circuit on a DC link of a vehicle. Maintenance work with regard to the capacitor (for example repair works or replacing) can be precisely timed. Therefore, costs and maintenance effort are reduced.

Implementation and utilization of the method are simple and cost-effective, particularly, since the underlying mathematical principles are simple and easy to implement and, furthermore, existing hardware, particularly usually already available in railway vehicles, can be used. So, no costly hardware update or hardware extension is needed. Furthermore, necessary computing power is very low.

When using the definite integral of the first time derivative and the definite integral of the second time derivative, disturbances in the sequence of values of a charging voltage (or a discharging voltage) can be advantageously compensated.

A further advantage with regard to embodiments in which the sequence of values of the discharging voltage is used is that this embodiment is not susceptible to scattering due to a change in supply voltage during performing the inventive method.

In an advantageous embodiment of the inventive method, the value of the first time derivative is determined by using numerical differentiation with regard to

- the whole evaluation time interval or
- a first subinterval of the evaluation time interval, wherein the first subinterval comprises at least three values of the charging voltage or the discharging voltage,

wherein the value of the second time derivative is determined by using numerical differentiation with regard to

- the whole evaluation time interval or
- a second subinterval of the evaluation time interval, wherein the second subinterval comprises at least three values of the charging voltage or the discharging voltage.

The evaluation time interval comprises, in this embodiment, at least 4 cycles with 5 sample values or 8 cycles with 9 sample values or 12 cycles with 13 sample values or 16 cycles with 17 sample values or 20 cycles with 21 sample values or more cycles.

The first subinterval can comprise, for example, at least 2 cycles, or 4 or 10 or 20 or more or the whole evaluation time interval. The value of the first time derivative (the slope) can be obtained by dividing the difference in values of the charging voltage (or the discharging voltage) at the beginning and at the end of the evaluation time interval or the first subinterval by the evaluation time interval (can be particularly the time span of it in (milli-) seconds) or the first subinterval (can be particularly the time span of it in (milli-) seconds), respectively.

The second subinterval can comprise, for example, at least 2 cycles, or 4 or 10 or 20 or more. The value of the second time derivative (the curvature) can be obtained by dividing the difference in values of the slope of the charging voltage (or the discharging voltage) at the beginning and at the end of the evaluation time interval (can be particularly the time span of it in (milli-) seconds) or the second subinterval by the evaluation time interval or the second subinterval (can be particularly the time span of it in (milli-) seconds).

The second subinterval can match with the first subinterval with regard to its length. The second subinterval can be larger or smaller than the first subinterval. The second subinterval can contain the first subinterval at least partially or vice-versa.

The presented embodiment of the inventive method allows for a more exact calculation of the capacitance value, since comparably long time intervals are considered for calculating it.

In an advantageous embodiment of the inventive method, a plurality of capacitance values is determined, wherein the plurality of capacitance values

- are qualified as usable if a predefined measure of statistical dispersion of the plurality of capacitance values is not exceeded and/or
- are qualified as unusable if a predefined measure of statistical dispersion of the plurality of capacitance values is exceeded.

Being qualified as usable can mean that the capacitance values in question are not discarded. They can be output, particularly used for further evaluation of aging. Being qualified as unusable can mean that the capacitance values in question are discarded or not used, particularly for an evaluation of aging of the capacitor. The plurality of capacitance values can be determined by performing the inventive method (at least partially) multiple times. The presented embodiment of the method can be performed at least partially automatically. Repeating the method at least partially and/or qualifying the plurality of capacitance values as usable or unusable can be performed by a computing device.

In a simple embodiment, a maximum value C_max and a minimum value C_min of the plurality of capacitance values are determined. A scattering of the plurality of capacitance values can be determined by calculating the result of (C_max - C_min)/C_max. If the result is below a predefined threshold value, the plurality of capacitance values can be qualified as usable. If the result is above a predefined threshold value, the plurality of capacitance values can be qualified as unusable.

High Scattering of capacitance values can - in embodiments in which the sequence of values of the charging voltage are used - occur when a supply voltage of the RC circuit can change particularly during determining the plurality of capacitance values. In this case, the inventive method may - at least partially - not be applicable, determined capacitance values may be invalid (the supply voltage of the RC circuit is, as a constant, present in the above-mentioned mathematical deviation). The presented embodiment allows to qualify such capacitance values as unusable. Valid capacitance values, on the other hand, are qualified as usable. The presented embodiment allows to ensure validity and a high informative value of determined capacitance values used for evaluation of aging.

In an advantageous embodiment of the inventive method, the capacitance value, and/or, if applicable, the plurality of capacitance values, are qualified as unusable, if a change in a supply voltage of the RC circuit is detected in the evaluation time interval.

The change in the supply voltage can be measured by a measuring device, particularly a voltmeter. If a change in the supply voltage is detected, the capacitance value and/or, if applicable, the plurality of capacitance values can be qualified as unusable automatically, for example by a computing device. Being qualified as unusable can mean that the capacitance value and/or, if applicable, the plurality of capacitance values in question is/are discarded or not used, particularly for an evaluation of aging of the capacitor.

The presented embodiment allows to ensure validity and a high informative value of determined capacitance values used for evaluation of aging. The present embodiment can particularly require, that the RC circuit comprises the charging resistor and that the sequence of values of the charging voltage is measured and used for further calculations to calculate the capacitance value.

Additionally, it is proposed a system for determining a capacitance value of a capacitor of a RC circuit on a DC link of a vehicle, wherein the RC circuit comprises a charging resistor or a discharging resistor, wherein the system is configured to perform the inventive method, wherein the system comprises:

a) a measuring device, configured to measure a sequence of values of a charging voltage or a discharging voltage of the capacitor over an evaluation time interval,
b) a computing device, configured to determine

- a value or
- a definite integral with respect to time
 of a first time derivative of the sequence of values of the charging voltage or the discharging voltage in the evaluation time interval and configured to determine
- a value or
- a definite integral with respect to time
 of a second time derivative of the sequence of values of the charging voltage or the discharging voltage in the evaluation time interval and configured to determine the capacitance value of the capacitor by using one of the following relations:
- the negative quotient of the value of the first time derivative and the value of the second time derivative, wherein the negative quotient is divided by a known resistance value of the charging resistor or the discharging resistor, gives the capacitance value, or
- the negative quotient of the definite integral of the first time derivative and the definite integral of the second time derivative, wherein the negative quotient is divided by a known resistance value of the charging resistor or the discharging resistor, gives the capacitance value.

The above-described features of the presented embodiments of the method according to the invention can be subject of the system according to the invention. With regard to the system according to the invention, full reference is made to the embodiments of the method according to the invention and vice versa.

Additionally, it is proposed a vehicle comprising the inventive system. The above-described features of the presented embodiments of the method and the system according to the invention can be subject of the vehicle according to the invention. With regard to the vehicle according to the invention, full reference is made to the embodiments of the method and the system according to the invention and vice versa. Particularly, the vehicle can be a railway vehicle.

Exemplary embodiments of the invention will now be described with reference to the accompanying drawing. The individual figures of the drawing show:

- Fig. 1: a schematic illustration of an embodiment of the inventive method,
- Fig. 2: a curve of an exemplary charging voltage over time (measured during carrying out the embodiment of the method presented in Fig. 1), wherein on the time axis (abscissa), cycles of 4 ms each are shown,
- Fig. 3: a schematic illustration of an embodiment of the inventive system used in the inventive method shown in Fig. 1,
- Fig. 4: a schematic illustration of a further embodiment of the inventive system.

Identical reference signs used in different figures mean identical, essentially identical or similar features. Not all features shown with reference symbols are described again for each figure.

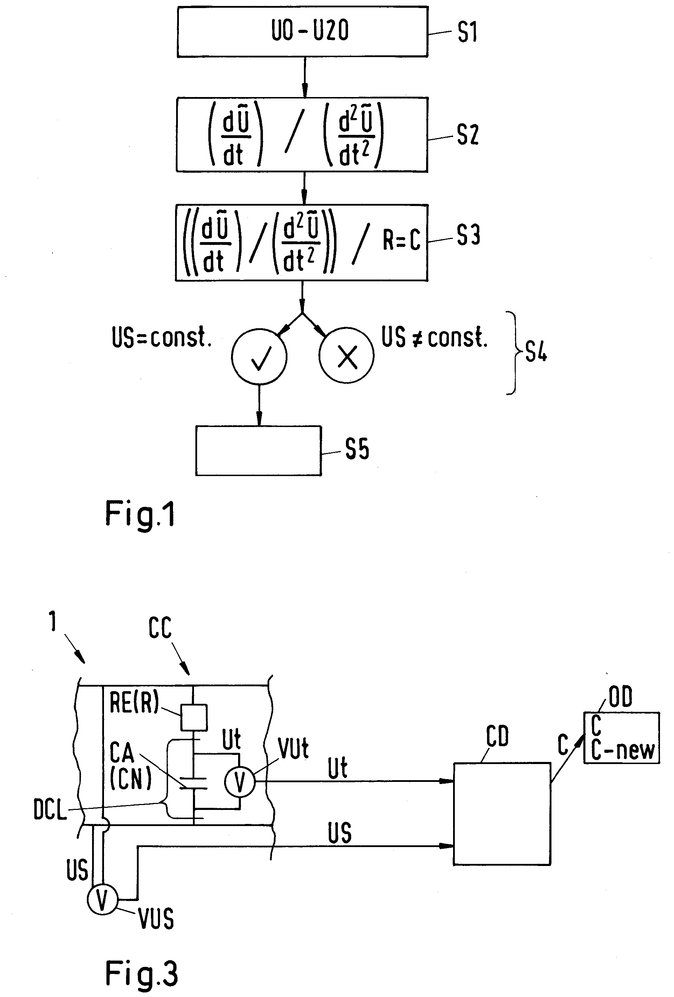

Fig. 1 shows a schematic illustration of an embodiment of the inventive method. Fig. 3 shows a schematic illustration of an embodiment of an inventive system 1 used for performing the inventive method shown in Fig. 1. In a first step S1, 21 values U0-U20 of a charging voltage Ut (which can be a DC link voltage) are measured using a voltmeter VUt (Fig. 3) and output to a computing device CD. With the charging voltage Ut (Fig. 3), a capacitor CA (Fig. 3) on a DC link DCL (Fig. 3) is charged. Fig. 3 shows a charging circuit CC. The capacitor CA is a part of the DC link (as a part of the DC link, only the capacitor CA is shown, other parts of the DC link are not shown). A resistor RE is provided that serves as a charging resistor. It is an additional component that particularly serves to limit a current when charging the capacitor CA. The resistor RE is connected to the DC link DCL, but not regarded as part of it. The DC link DCL is part of a traction converter of a railway vehicle, namely a traction wagon of a tramway. The capacitor CA is provided in series connection with the resistor RE (Fig. 3). Both constitute a RC circuit on the DC link DCL. A supply voltage value US (Fig. 3) is (optionally) measured in the charging circuit CC with the aid of a second voltmeter VUS (Fig. 3) and output to the computing device CD.

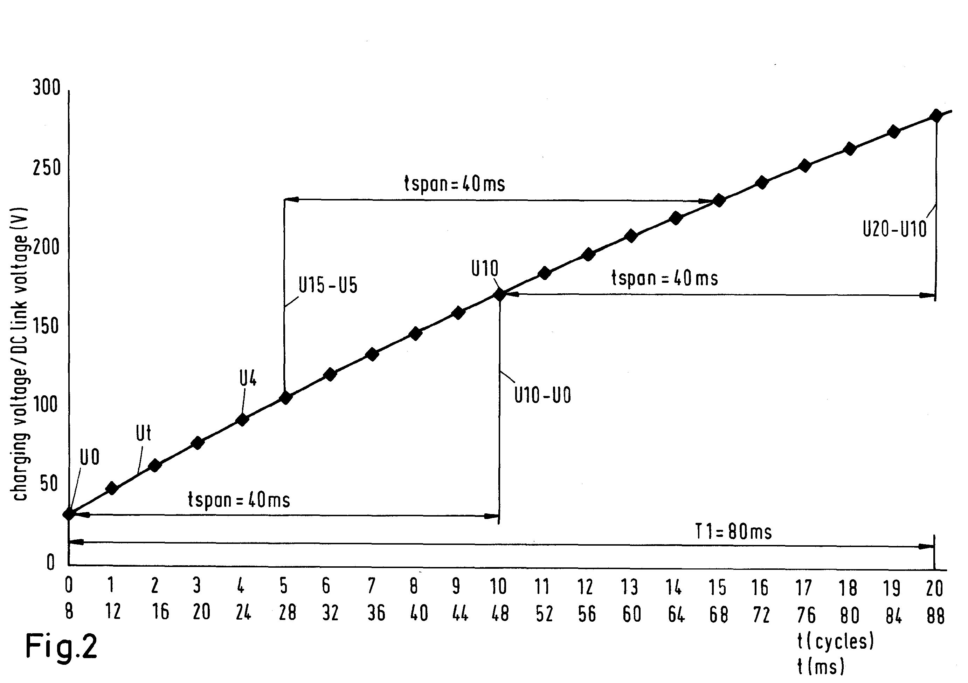

Fig. 2 shows the 21 values U0-U20 of the charging voltage Ut (connected, in each case, by interpolation, the result is a curve of the charging voltage Ut), which are measured at 21 points in time, wherein the points are - in each case - separated by predefined time durations of 4 ms. That is, a step size is 4 ms. The value U0 is measured 8 ms after a beginning of a charging process, wherein charging begins with a charging voltage of 0 V. The 20 time durations (or cycles) between the 21 points in time correspond to an evaluation time interval T1 (Fig. 2) having a length of 80 ms from index 0 to index 20.

By way of example, the following quantities are known or measured:

- known resistance value R of the resistor RE: 68 Ohm,
- known nominal capacitance value CN of the capacitor CA: 2.7 mF,
- measured supply voltage value US: 750 V,
- value U0 of charging voltage Ut = 32.0 V,
- value U5 of charging voltage Ut = 106.1 V,
- value U10 of charging voltage Ut = 172.5 V,
- value U15 of charging voltage Ut = 232.1 V,
- value U20 of charging voltage Ut = 285.6 V.

In a second step S2, a quotient of a value of a first time derivative of the charging voltage Ut and a value of a second time derivative of the charging voltage Ut are determined by numerical differentiation in each case over 10 cycles (10 cycles or 40 ms is denoted as time duration tspan, tspan = 40 ms).

The value of the first time derivative is (U15 - U5)/tspan. A subinterval of the evaluation time interval T1 from index 5 to 15 is used for calculation.

The value of the second time derivative is [(U20 - U10)/tspan - (U10 - U0)/tspan]/tspan. Subintervals of the evaluation time interval T1 from index 10 to 20 and index 0 to 10 are used for calculation.

Fig. 2 illustrates the given differences (U15 - U5, U10 - U0, U20 - U10) on the curve of the charging voltage Ut. On the time axis, 20 cycles (4 ms each) and 21 points in time are shown on the abscissa.

It should be noted that, if different time durations were used for calculating the first time derivative (for example 50 ms) and calculating the second derivative (for example 20 ms), different designations for those time durations would have to be used. For the sake of simplicity, the time duration tspan is used in both cases above. This is possible, since the used subintervals each have matching lengths which correspond to the time duration tspan.

In a third step S3, the negative quotient of the value of the first time derivative and the value of the second time derivative is determined. This quotient equals the time constant tau of the RC circuit:

$$\text{tau} = - \{(U15 - U5)/\text{tspan}\}/\{[(U20 - U10)/\text{tspan} - (U10 - U0)/\text{tspan}]/\text{tspan}\} <=>$$

$$\text{tau} = - (U15 - U5)/((U20 - U10) - (U10 - U0))*\text{tspan} <=>$$

$$\text{tau} = - (U15 - U5)/(U20 + U0 - 2*U10)*\text{tspan} <=>$$

$$\text{tau} = - (232.1\ V - 106.1\ V)/(285.6\ V + 32.0\ V - 2*172.5\ V)*40\ ms = 183.9\ ms.$$

It follows for a capacitance value C of the the capacitor CA:

$$C = \text{tau} / R = 183.9\ ms / 68\ Ohm = 2.705\ mF.$$

A relative deviation of the capacitance value C in comparison to the nominal capacitance value CN (2.7 mF) of +0.2 % is detected:

$$(2.705 \text{ mF} - 2.7 \text{ mF})/2.7 \text{ mF} = 0.2\%.$$

After a period of time (for example 5 or 10 years), the calculation (first step S1, second step S2, third step S3) is repeated. New values or results are marked with the suffix "-new". The following new values are determined (values not stated remain the same, the new values are not shown in Fig. 2):

- new value U0-new of charging voltage Ut = 33.6 V,
- new value U5-new of charging voltage Ut = 111.2 V,
- new value U10-new of charging voltage Ut = 180.4 V,
- new value U15-new of charging voltage Ut = 242.1 V,
- new value U20-new of charging voltage Ut = 297.2 V.

A repetition of the above-explained calculation with the stated new values gives:

$$\text{tau-new} = - (\text{U15-new} - \text{U5-new})/(\text{U20-new} + \text{U0-new} - 2*\text{U10-new})*\text{tspan} <=>$$

$$\text{tau-new} = - (242.1 \text{ V} - 111.2 \text{ V})/(297.2 \text{ V} + 33.6 \text{ V} - 2*180.4 \text{ V})*40 \text{ ms} = 174.5 \text{ ms}.$$

It follows for a new capacitance value C-new of the capacitor CA:

$$\text{C-new} = \text{tau-new} / R = 174.5 \text{ ms} / 68 \text{ Ohm} = 2.567 \text{ mF}.$$

C-new: 2.567 mF.

The above-mentioned calculations are carried out by the computing device CD (Fig. 3) and are output by means of an output device OD. The output device OD can be, for example, a display and/or a monitor showing the numerical values of the capacitance value C and the new capacitance value C-new and the relative deviations in comparisons to the nominal capacitance value CN. The output device can alternatively or additionally be an interface to a data storage, for example an error memory of the railway vehicle.

During determinations of the charging voltage values, the supply voltage value US was constantly checked by the computing device CD. A change of the supply voltage value US was not detected. This is shown in Fig. 1 as a fourth step S4. Since the mentioned measurements and calculations were not affected by a change of the supply voltage value US, the capacitance value C and the new capacitance value C-new are qualified as usable by the computing device CD.

Alternatively to the fourth step S4 or additionally to the fourth step S4, the computing device CD can be configured perform a predefined measure of statistical dispersion. In this case, a plurality of capacitance values has to be determined in advance by using the inventive method at least partially so that a possible scattering can be detected. Wrong capacitance values affected by too high scattering are discarded. The supply voltage values US are not necessary in this case.

In a fifth step S5, a relative deviation of the capacitance value C-new in comparison to the nominal capacitance value CN (2.7 mF) of -4.9 % is detected:

$$(2.567 \text{ mF} - 2.7 \text{ mF})/2.7 \text{ mF} = -4.9\%.$$

This decrease in comparison to the nominal value shows aging of the capacitor CA during the time period.

Derivation using difference quotients (in each case over a time duration tspan having a length of 40 ms) instead of using differential quotient (over an infinitesimal small time span) comprise a systematic error. In order to limit relative errors to less than 0.2 %, a ratio of (time constant tau / time duration tspan used for differentiation) > 5 is recommended. In the presented calculation examples, additional errors occur due to a rounding of intermediate results. The systematic error and the additional error both are small and do not (or only negligibly) affect information values of results with regard to a determination of aging.

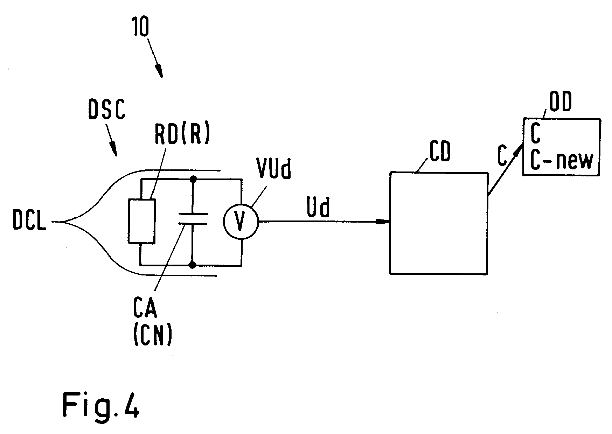

The presented embodiment of the method described above (more exact: first step S1, second step S2, third step S3) can also be mutatis mutandis used for calculating the capacitance value C by using a sequence of values of a discharging voltage Ud, see Fig. 4, of a capacitor CA. The inventive system 10 required as shown in Fig. 4 would differ from the inventive system 1 as shown in Fig. 3: Now, a provided resistor RD is a discharging resistor. It is connected in parallel with the capacitor CA in a closed discharging circuit DSC. The resistor RD is a passive discharging resistor. The capacitor CA is - as in the inventive system 1 shown in Fig. 3 - a part of a DC link (as a part of the DC link, only the capacitor CA is shown, other parts of the DC link are not shown).

The values of the discharging voltage Ud are determined by using a voltmeter VUd and used for further calculations as explained above instead of the values U0-U20 of the charging voltage Ut. This also applies to repetitions of the method (first step S1, second step S2, third step S3) after a period of time (for example 5 or 10 years) in which new values of the discharging voltage Ud are examined. At the end, the fifth step S5 can be applied mutatis mutandis to assess aging of the capacitor CA.

The fourth step S4 is not performed in this embodiment of the method, since a supply voltage may not be available and is not needed. Instead, the computing device CD is configured to perform a predefined measure of statistical dispersion. In this case, a plurality of capacitance values has to be determined in advance by using the inventive method at least partially so that a possible scattering can be detected. Wrong capacitance values affected by too high scattering are discarded. The supply voltage values US are not necessary.

The inventive system 10 and - generally - determining capacitance values (here: capacitance value C) by means of a discharging resistor (here: resistor RD) has the advantage, that no external influences like a varying supply voltage occur. As a result, determining capacitance values by means of a discharging resistor is particularly reliable.

Reference signs:

1: inventive system
10: inventive system
C: capacitance value of capacitor
CA: capacitor
CC: charging circuit
CD: computing device
CN: nominal capacitance value of capacitor
C-new: new capacitance value of capacitor
DCL: DC link
DSC: discharging circuit
OD: output device
R: resistance value
RD: (discharging) resistor
RE: (charging) resistor
S1-S5: steps 1-5
T1: evaluation time interval
tspan: time duration
U0-new-U20-new: new values of the charging voltage
U0-U20: values of the charging voltage
Ud: discharging voltage
US: supply voltage value
Ut: charging voltage
VUd: voltmeter
VUS: second voltmeter
VUt: voltmeter

## Claims

1. A method for determining a capacitance value (C) of a capacitor (CA) of a RC circuit on a DC link (DCL) of a vehicle, wherein the RC circuit comprises a charging resistor (RE) or a discharging resistor (RD), the method comprising the following steps:

   a) measuring a sequence of values (U0-U20; U0-new-U20-new) of a charging voltage (Ut) or a discharging voltage (Ud) of the capacitor (CA) over an evaluation time interval (T1),

b) determining

- a value or
- a definite integral with respect to time

of a first time derivative of the sequence of values (U0-U20; U0-new-U20-new) of the charging voltage (Ut) or the discharging voltage (Ud) in the evaluation time interval (T1),

c) determining

- a value or
- a definite integral with respect to time

of a second time derivative of the sequence of values (U0-U20; U0-new-U20-new) of the charging voltage (Ut) or the discharging voltage (Ud) in the evaluation time interval (T1),

d) determining the capacitance value (C) of the capacitor (CA) by using one of the following relations:

- the negative quotient of the value of the first time derivative and the value of the second time derivative, wherein the negative quotient is divided by a known resistance value (R) of the charging resistor (RE) or the discharging resistor (RD), gives the capacitance value (C), or
- the negative quotient of the definite integral of the first time derivative and the definite integral of the second time derivative, wherein the negative quotient is divided by a known resistance value (R) of the charging resistor (RE) or the discharging resistor (RD), gives the capacitance value (C).

2. The method according to claim 1, **characterized in that** the value of the first time derivative is determined by using numerical differentiation with regard to

- the whole evaluation time interval (T1) or
- a first subinterval of the evaluation time interval (T1), wherein the first subinterval comprises at least three values (U0-U20; U0-new-U20-new) of the charging voltage (Ut) or the discharging voltage (Ud),

wherein the value of the second time derivative is determined by using numerical differentiation with regard to
- the whole evaluation time interval (T1) or
- a second subinterval of the evaluation time interval (T1), wherein the second subinterval comprises at least three values (U0-U20; U0-new-U20-new) of the charging voltage (Ut) or the discharging voltage (Ud).

3. The method according to claim 1 or 2, **characterized in that** a plurality of capacitance values (C) is determined, wherein the plurality of capacitance values (C)

- are qualified as usable if a predefined measure of statistical dispersion of the plurality of capacitance values (C) is not exceeded and/or
- are qualified as unusable if a predefined measure of statistical dispersion of the plurality of capacitance values (C) is exceeded.

4. The method according to any one of claims 1-3, **characterized in that** the capacitance value (C), and/or, if applicable, the plurality of capacitance values (C), are qualified as unusable, if a change in a supply voltage (US) of the RC circuit is detected in the evaluation time interval (T1).

5. A system (1, 10) for determining a capacitance value (C) of a capacitor (CA) of a RC circuit on a DC link (DCL) of a vehicle, wherein the RC circuit comprises a charging resistor (RE) or a discharging resistor (RD), wherein the system (1) is configured to perform the method according to any one of claims 1-4, wherein the system (1) comprises:

a) a measuring device, configured to measure a sequence of values (U0-U20; U0-new-U20-new) of a charging voltage (Ut) or a discharging voltage (Ud) of the capacitor (CA) over an evaluation time interval (T1),
b) a computing device, configured to determine

- a value or
- a definite integral with respect to time

of a first time derivative of the sequence of values (U0-U20; U0-new-U20-new) of the charging voltage (Ut) or the discharging voltage (Ud) in the evaluation time interval (T1) and configured to determine

- a value or
- a definite integral with respect to time

of a second time derivative of the sequence of values (U0-U20; U0-new-U20-new) of the charging voltage (Ut) or the discharging voltage (Ud) in the evaluation time interval (T1) and configured to determine the capacitance value (C) of the capacitor (CA) by using one of the following relations:

    - the negative quotient of the value of the first time derivative and the value of the second time derivative, wherein the negative quotient is divided by a known resistance value (R) of the charging resistor (RE) or the discharging resistor (RD), gives the capacitance value (C), or
    - the negative quotient of the definite integral of the first time derivative and the definite integral of the second time derivative, wherein the negative quotient is divided by a known resistance value (R) of the charging resistor (RE) or the discharging resistor (RD), gives the capacitance value (C).

6. A vehicle comprising the system (1, 10) according to claim 5.

7. The vehicle according to claim 6, **characterized in that** the vehicle is a railway vehicle.

$$U0 - U20 \quad\text{—— S1}$$

$$\left(\frac{d\tilde{U}}{dt}\right) \Big/ \left(\frac{d^2\tilde{U}}{dt^2}\right) \quad\text{—— S2}$$

$$\left|\left(\left(\frac{d\tilde{U}}{dt}\right)\Big/\left(\frac{d^2\tilde{U}}{dt^2}\right)\right)\right| \Big/ \; R = C \quad\text{—— S3}$$

US = const. $\checkmark$ $\times$ US ≠ const. $\Big\}$ S4

S5

## Fig.1

## Fig.3

Fig.2

EP 4 741 842 A1

10

DSC

RD(R)

VUd

DCL

CA
(CN)

Ud

CD

OD

C
C-new

C

Fig.4

Europäisches
Patentamt
European
Patent Office
Office européen
des brevets

# EUROPEAN SEARCH REPORT

**Application Number**

EP 24 30 6865

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/230745 A9 (BENDER GMBH & CO KG [DE]) 11 July 2024 (2024-07-11) * abstract; claims 1-14; figures 1-12 * * paragraph [0013] - paragraph [0049] * * paragraph [0063] - paragraph [0110] * ----- | 1-7 | INV. G01R27/26 |
| A | US 4 347 740 A (TOWNSEND LAWRENCE B) 7 September 1982 (1982-09-07) * abstract; claims 1-3; figure 1 * * column 1, line 34 - line 54 * * column 1, line 64 - column 4, line 2 * ----- | 1-7 | |
| A | US 2011/133757 A1 (CHAE KYOUNG SOO [KR] ET AL) 9 June 2011 (2011-06-09) * abstract; claims 1-17; figures 1-6 * * paragraph [0011] - paragraph [0028] * * paragraph [0038] - paragraph [0100] * ----- | 1-7 | |
| A | CN 114 840 991 A (UNIV HARBIN SCIENCE & TECH) 2 August 2022 (2022-08-02) * the whole document * ----- | 1-7 | **TECHNICAL FIELDS SEARCHED (IPC)** G01R |

The present search report has been drawn up for all claims

| Place of search | Date of completion of the search | Examiner |
|---|---|---|
| Munich | 23 April 2025 | Nadal, Rafael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 741 842 A1**

## ANNEX TO THE EUROPEAN SEARCH REPORT
## ON EUROPEAN PATENT APPLICATION NO.

EP 24 30 6865

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2025

| Patent document cited in search report | | Publication date | Patent family member(s) | | Publication date |
|---|---|---|---|---|---|
| US 2024230745 | A9 | 11-07-2024 | CN | 117929848 A | 26-04-2024 |
| | | | DE | 102022128126 B3 | 01-02-2024 |
| | | | EP | 4361649 A1 | 01-05-2024 |
| | | | US | 2024133939 A1 | 25-04-2024 |
| US 4347740 | A | 07-09-1982 | CA | 1163826 A | 20-03-1984 |
| | | | DE | 3042886 A1 | 03-09-1981 |
| | | | FR | 2469716 A1 | 22-05-1981 |
| | | | GB | 2064136 A | 10-06-1981 |
| | | | JP | S5684522 A | 09-07-1981 |
| | | | MX | 148845 A | 24-06-1983 |
| | | | US | 4347740 A | 07-09-1982 |
| US 2011133757 | A1 | 09-06-2011 | JP | 2011119637 A | 16-06-2011 |
| | | | KR | 20110062990 A | 10-06-2011 |
| | | | US | 2011133757 A1 | 09-06-2011 |
| CN 114840991 | A | 02-08-2022 | NONE | | |

EPO FORM P0459

For more details about this annex : see Official Journal of the European Patent Office, No. 12/82